# EUROPEAN PATENT APPLICATION

(11) **EP 4 780 174 A1**
(43) Date of publication of application: **22.07.2026**
(21) Application number: 24864784.4
(22) Date of filing: 14.09.2024
(51) Int. Cl.: H10H 20/851, H10H 20/857, H10H 20/812

(54) **QUANTUM DOT LED CHIP, LED PACKAGE DEVICE, AND LIGHT-EMITTING APPARATUS**

(30) Priority: 15.09.2023 CN 202311204158; 11.12.2023 CN 202311701497
(71) Applicant: Huizhou Jufei Optoelectronics Co., Ltd, Huizhou, Guangdong 516025 (CN)
(72) Inventor: MA, Wenbo, Huizhou, Guangdong 516025 (CN); SUN, Pingru, Huizhou, Guangdong 516025 (CN); XING, Meizheng, Huizhou, Guangdong 516025 (CN)
(74) Representative: Viering, Jentschura & Partner mbB Patent- und Rechtsanwälte
(86) International application number: PCT/CN2024/119152
(87) International publication number: WO 2025/056069

(57) **Abstract**

The present application relates to a quantum dot LED chip, a manufacturing method thereof, a package device and a light-emitting device. The quantum dot LED chip includes a carrier, which is formed of a light-transmitting solid material, with a plurality of nanopores on the surface or inside the carrier, the nanopores being loaded with a quantum dot material. The carrier is arranged on the quantum dot LED chip and located above the multiple-quantum-well light-emitting layer of the quantum dot LED chip, and light emitted from the multiple-quantum-well light-emitting layer of the quantum dot LED chip can excite the quantum dot material to convert the wavelength emitted by the chip. In the present application, the quantum dot material is packaged on the LED chip, which can improve the excitation efficiency of quantum dots and reduce the usage of the quantum dot material.

## Description

### TECHNICAL FIELD

The present application relates to the technical field of display devices, and in particular to a quantum dot LED chip, an LED package device, and a light-emitting device.

### BACKGROUND

In recent years, as user requirements for the performance experience of display devices continue to increase, high-color-gamut display devices have become more popular among consumers. As an indicator widely used in the industry to measure the color performance of display devices, a higher NTSC color gamut value means richer and more prominent color effects and more realistic color reproduction. Among these, because the application of quantum dot technology in the display field can achieve an ultra-wide color gamut, its application methods have attracted great attention in the industry.

### SUMMARY

It is an object of the present application to provide a quantum dot LED chip, a package device using the quantum dot LED chip, and a light-emitting device.

The present application provides a quantum dot LED chip, including a carrier and a multiple-quantum-well light-emitting layer. The carrier is formed of a light-transmitting solid material, wherein a plurality of nanopores are formed on the surface or within the carrier, and the nanopores are loaded with a quantum dot material. The carrier is positioned above the multiple-quantum-well light-emitting layer, allowing light emitted from the multiple-quantum-well structure of the LED chip to excite the quantum dot material, thereby converting the wavelength of the light emitted by the chip.

In the present application, a plurality of micropores, i.e., nanopores, are formed in the carrier, so that quantum dots can be accommodated therein. Since the carrier forms part of the LED chip, light emitted by the chip can effectively excite the quantum dots, achieving a high color gamut display effect, while also reducing the amount of quantum dots used and lowering costs.

Further applications of the quantum dot LED chip are described in the specific embodiments below.

### BRIEF DESCRIPTION OF DRAWINGS

To more clearly illustrate the technical features in the embodiments of the present application or the prior art, the accompanying drawings used for describing the embodiments or the prior art are briefly introduced below. Obviously, the drawings in the following description are only some embodiments of the present application. For those of ordinary skill in the art, other drawings can be obtained based on these drawings without creative effort.

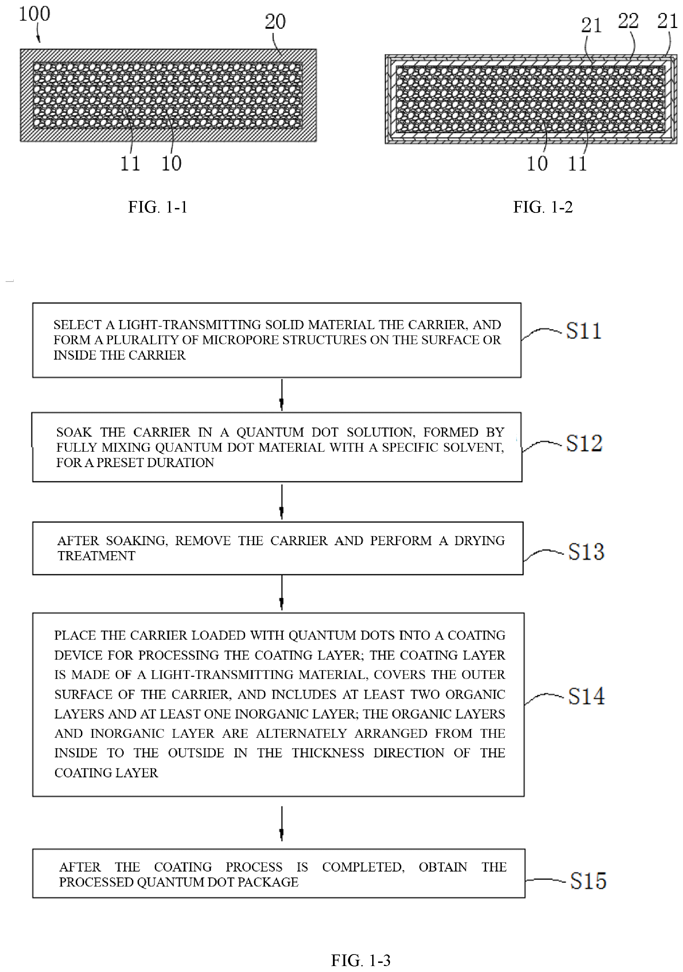

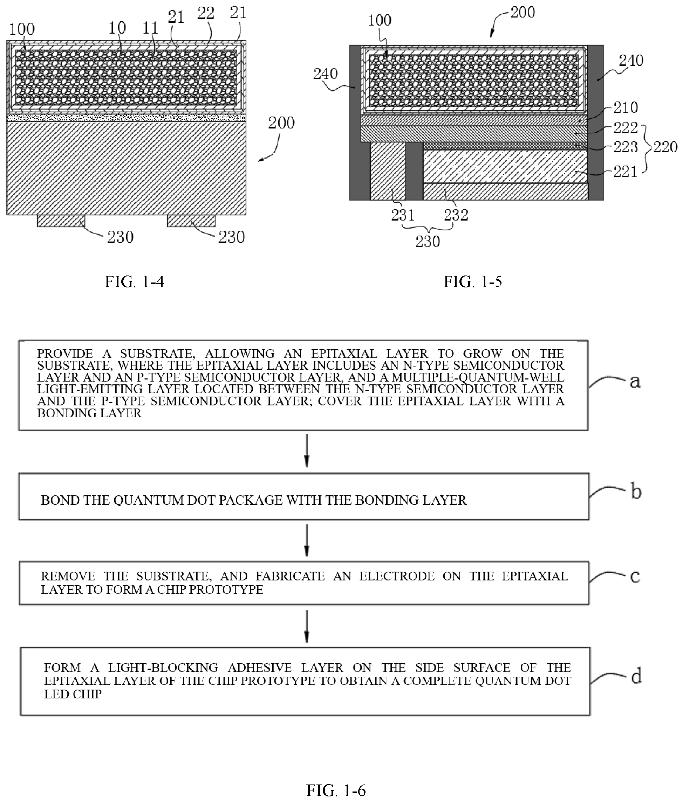

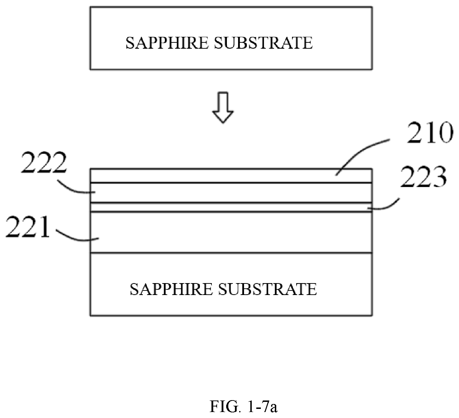

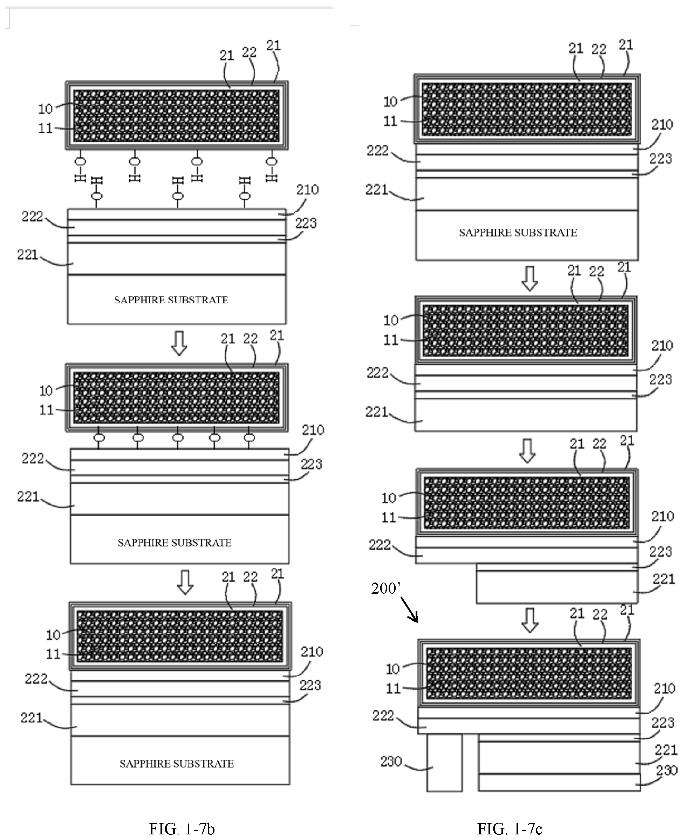

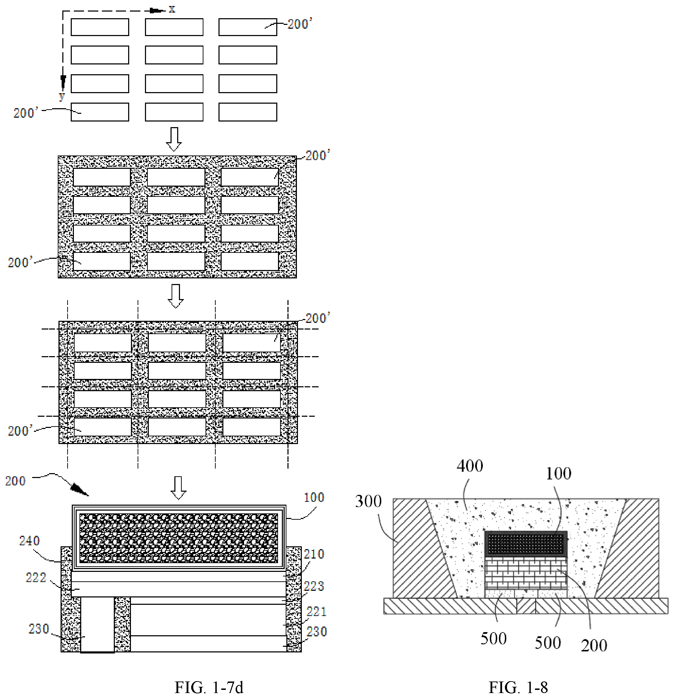

FIG. 1-1 is a schematic structural diagram of a quantum dot package provided in an embodiment;
FIG. 1-2 is a detailed structural diagram of the coating layer in FIG. 1-1;
FIG. 1-3 is a flowchart of steps for a manufacturing method of a quantum dot package provided in an embodiment;
FIG. 1-4 is a schematic structural diagram of a quantum dot LED chip provided in an embodiment;
FIG. 1-5 is a schematic structural diagram of a quantum dot LED chip provided in an embodiment;
FIG. 1-6 is a flowchart of steps for a manufacturing method of a quantum dot LED chip provided in an embodiment;
FIG. 1-7a is a schematic diagram of step a in the quantum dot LED chip manufacturing method provided in FIG. 1-6;
FIG. 1-7b is a schematic diagram of step b in the quantum dot LED chip manufacturing method provided in FIG. 1-6;
FIG. 1-7c is a schematic diagram of step c in the quantum dot LED chip manufacturing method provided in FIG. 1-6;
FIG. 1-7d is a schematic diagram of step d in the quantum dot LED chip manufacturing method provided in FIG. 1-6;
FIG. 1-8 is a schematic structural diagram of an LED package device provided in an embodiment;
FIG. 2-1 shows a top-view structural schematic of a chip group provided by one example in Embodiment 4 or a light source assembly provided by one example in Embodiment 5;

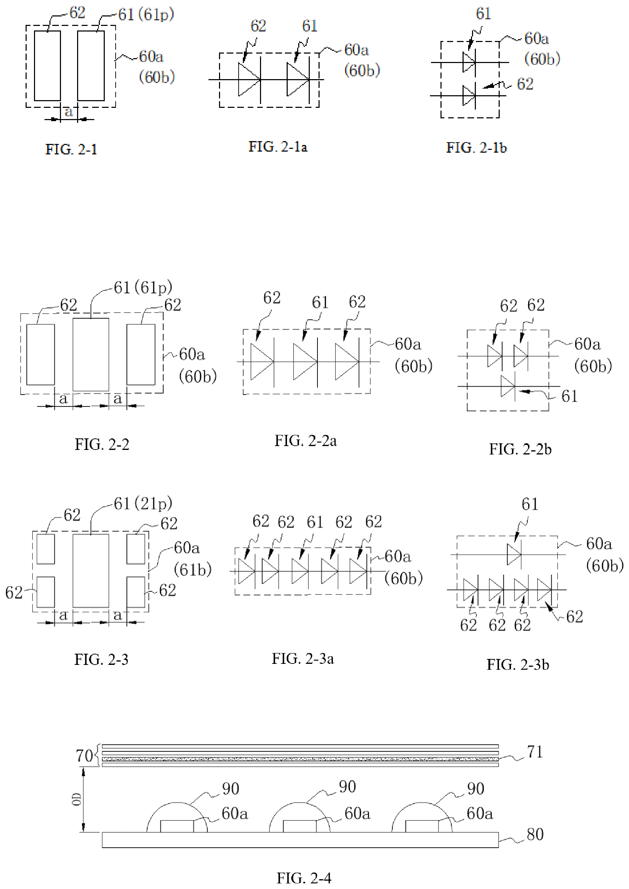

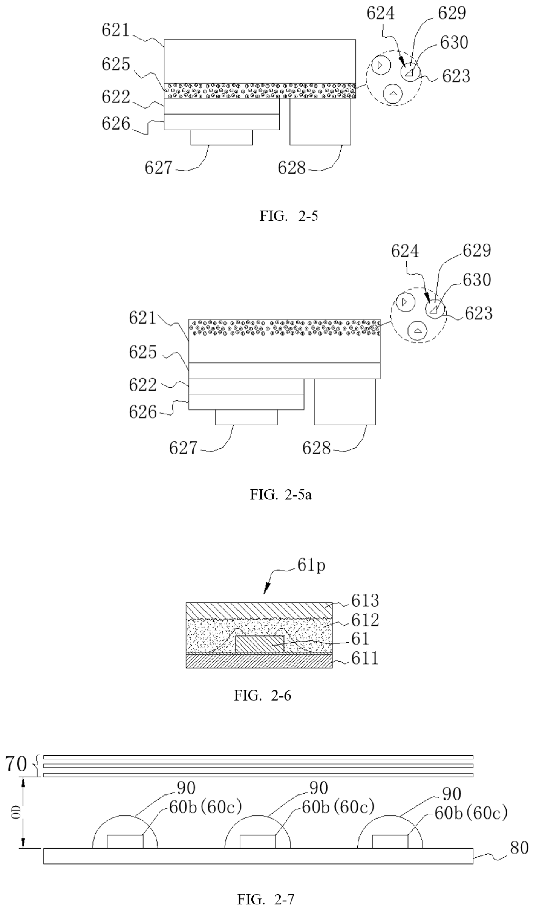

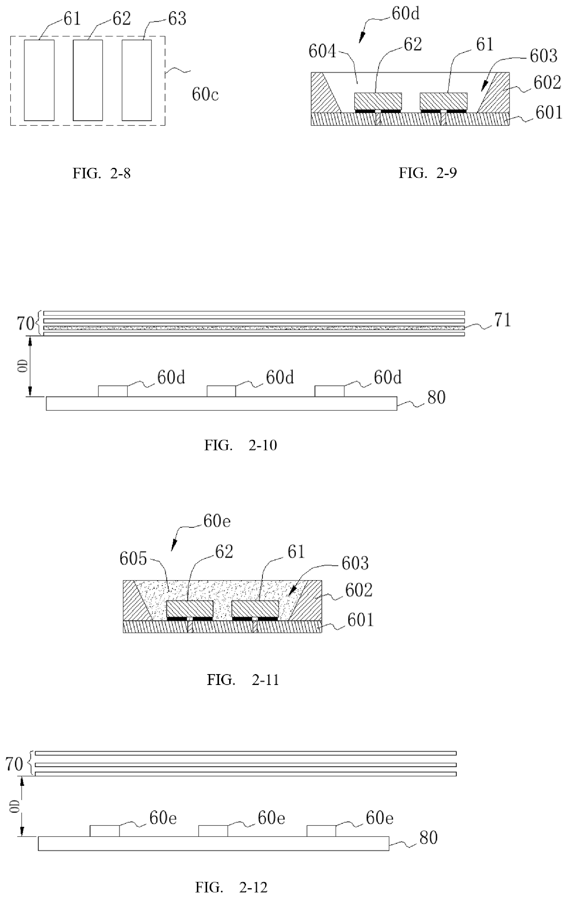

FIGS. 2-1a and 2-1b show circuit schematics of each chip in the chip group or light source assembly provided in FIG. 2-1;
FIG. 2-2 shows a top-view structural schematic of another example chip group provided in Embodiment 4 or another example light source assembly provided in Embodiment 5;
FIGS. 2-2a and 2-2b show circuit schematics of each chip in the chip group or light source assembly provided in FIG. 2-2;
FIG. 2-3 shows a top-view structural schematic of another example chip group provided in Embodiment 4 or another example light source assembly provided in Embodiment 5;
FIGS. 2-3a and 2-3b show circuit schematics of each chip in the chip group or light source assembly provided in FIG. 2-3;
FIG. 2-4 shows a structural schematic of a light-emitting device provided in Embodiment 4;
FIG. 2-5 shows a structural schematic of a quantum dot LED chip provided by one example in Embodiment 4;
FIG. 2-5a shows a structural schematic of another example quantum dot LED chip provided in Embodiment 4;
FIG. 2-6 shows a structural schematic of an LED package device provided by one example in Embodiment 5;
FIG. 2-7 shows a structural schematic of a light-emitting device provided in Embodiment 5;
FIG. 2-8 shows a top-view structural schematic of a chip group provided by one example in Embodiment 6;
FIG. 2-9 shows a structural schematic of an LED package device provided in Embodiment 7;
FIG. 2-10 shows a structural schematic of a light-emitting device provided in Embodiment 7;
FIG. 2-11 shows a structural schematic of an LED package device provided in Embodiment 8;
FIG. 2-12 shows a schematic structural diagram of the light-emitting device provided in Embodiment 8.

### DESCRIPTION OF EMBODIMENTS

To facilitate understanding of the present application, a more comprehensive description of the present application will be given below with reference to the accompanying drawings. Preferred embodiments of the present application are provided in the drawings. However, the present application may be implemented in many different forms and is not limited to the embodiments described herein. On the contrary, these embodiments are provided to make the understanding of the disclosure of the present application more thorough and comprehensive.

It should be noted that when an element is referred to as being "fixed to" another element, it can be directly on the other element or intervening elements may also be present. When an element is considered to be "connected" to another element, it can be directly connected to the other element or intervening elements may be present simultaneously. The terms "vertical," "horizontal," "left," "right," and similar expressions used herein are for illustrative purposes only.

Unless otherwise defined, all technical and scientific terms used herein have the same meanings as commonly understood by those skilled in the technical field of the present application. The terminology used in the specification of the present application herein is for the purpose of describing specific embodiments only and is not intended to limit the present application. The term "and/or" used herein includes any and all combinations of one or more related listed items.

### Embodiment 1

The quantum dot LED chip in this embodiment includes a quantum dot package 100 disposed on the LED chip, wherein the quantum dot package 100 may be manufactured separately first and then combined with the LED chip to form the quantum dot LED chip. The quantum dot package 100 will first be described. Please refer to FIGS. 1-1 and 1-2, which show a quantum dot package 100 according to one embodiment, including a carrier 10 and a coating layer 20. The carrier 10 is formed of a light-transmitting solid material, and a plurality of micropores are formed on the surface of the carrier 10 or within the carrier 10, or both. In this embodiment, the carrier 10 is glass 11, and the surface of the glass 11 is distributed with a plurality of micropores, with quantum dots loaded inside the micropores. In other embodiments, the carrier 10 may also be other light-transmitting solid material (such as crystal or ALON).

In this embodiment, preferably, the main components of the glass 11 include a mass fraction of not less than 96% of SiO₂, 1%-3% of B₂O₃, and 1%-3% of Al₂O₃. The micropores are nanopores, with a pore diameter of from 5nm to 15nm, and the total pore volume of all micropores accounts for 25% to 40% of the volume of the glass 11.

In this embodiment, the coating layer 20 covers the outer surface of the glass 11 (i.e., the carrier 10). The coating layer 20 includes at least two organic layers 21 and at least one inorganic layer 22, the layers being alternately arranged from inside to outside along the thickness direction of the coating layer 20. For example, the coating layer 20 may have 3, 4, 5, or other numbers of layers. Theoretically, more layers provide better protection for the outer surface of the glass 11, but at a higher cost, and may be set according to actual needs.

Please refer to FIGS. 1-3. The present application further provides a manufacturing method for manufacturing the aforementioned quantum dot package 100, which includes the following steps:

S11: a light-transmitting solid material is selected as the carrier 10, and a plurality of micropores are formed on the surface or within the carrier 10.

In this embodiment, the carrier 10 is glass 11. The preparation method may include: placing the glass 11 in an acidic solution (such as sulfuric acid or hydrofluoric acid), so that the acidic solution corrodes specific components in the glass 11, thereby forming recessed micropores on the surface or both the surface and interior of the glass 11, thus obtaining the carrier 10.

S12: the carrier 10 is soaked in a quantum dot solution, formed by mixing quantum dot material with a specific solvent for a preset duration.

Here, the quantum dot material may be one or more of red-emitting or green-emitting materials such as CdS, ZnS, CdSe, InP, with a particle size of 1nm to 10nm. The solvent may be selected from volatile solvents such as acetone, ethyl acetate, toluene, DMF (dimethylformamide) and similar solvents. By placing the quantum dots into the solvent and stirring evenly, the quantum dot solution is prepared.

In this embodiment, the glass 11 is soaked in the quantum dot solution for a preset duration.

Depending on actual processing needs, the preset duration may range from 1 hour to 12 hours. The soaking process may be conducted at atmospheric pressure or under high pressure (above atmospheric pressure). In some embodiments, the soaking process is performed under high pressure, as it can save soaking time, allow the quantum dot solution to penetrate deeper into the glass 11, and reduce bubbles within the glass 11.

S13: after the soaking process, the carrier 10 is removed and a drying treatment is carried out.

In this embodiment, the glass 11 is removed and undergoes a drying treatment.

It should be noted that before drying the glass 11, a volatile solvent may be used to clean the glass 11 first, followed by drying, which helps to more thoroughly remove impurities on the surface of the glass 11 and improve the bonding quality of the subsequent coating layer 20.

S14: the carrier 10 loaded with quantum dots is disposed into a coating device for forming the coating layer 20. The coating layer 20 is formed of a light-transmitting material, covers the outer surface of the carrier 10, and includes at least two organic layers 21 and at least one inorganic layer 22. The organic layers 21 and inorganic layer 22 are alternately arranged from the inside to the outside in the thickness direction of the coating layer 20.

In this embodiment, the carrier 10 loaded with quantum dots is disposed into a coating device for processing the coating layer 20. Optionally, the coating device may be, but is not limited to, any one of PECVD (plasma enhanced chemical vapor deposition) or ALD (Atomic layer deposition) equipment.

S15: after the coating process is completed, the processed quantum dot package 100 is obtained.

Implementing the embodiments of the present application provides the following beneficial effects. In the quantum dot package 100 of the present application, a plurality of micropores, i.e., nanopores, are formed in the carrier 10 (glass 11 in this embodiment), such that the micropores can accommodate quantum dots, thereby enabling the carrier 10 to load the quantum dots. Furthermore, a coating layer 20 is formed on the exterior of the carrier 10 to encapsulate the quantum dots. In the present application, the coating layer 20 adopts a multilayer structure design including at least two organic layers 21 and at least one inorganic layer 22, wherein the organic layers 21 and the inorganic layer 22 are alternately arranged from the inside to the outside in the thickness direction of the coating layer 20. Compared with encapsulation methods using resin or silicone in the prior art, the inorganic layer 22 provides better barrier performance against water and oxygen than resin and silicone. However, the inorganic layer 22 is prone to cracking. Therefore, organic layers 21 are further disposed around the inorganic layer 22 for protection. The organic layers 21 have certain flexibility and can compensate for the cracking tendency of the inorganic layer 22. Meanwhile, the organic layers 21 have relatively poor airtightness and are prone to yellowing. Therefore, the inorganic layer 22 is disposed outside the organic layers 21 to improve the insufficient airtightness and yellowing tendency of the organic layers 21. In the present application, the molecules of the inorganic layer 22 are relatively small and can easily penetrate between the large molecular chains of the organic layers 21, thereby providing excellent barrier properties against water and oxygen. The organic layers 21 and the inorganic layer 22 are combined to complement each other's advantages, thereby providing airtight protection for the quantum dot package 100 and contributing to improved display performance. In this embodiment, the material of the organic layer 21 is acrylic, the material of the inorganic layer 22 is any one of AlN, Al₂O₃, Si₄N₃ and SiO₂, and the material of the glass 11 is primarily SiO₂.

In an optional embodiment, the number of coating layers 20 is set to an odd number (2n+1 layers, where n is a non-zero natural number), for example, the number of coating layers 20 may be one of 3, 5, 7, or 11 layers. Both the innermost layer and the outermost layer in the thickness direction of the coating layer 20 are organic layer 21, and the organic layer 21 at the innermost layer is in direct contact with the carrier 10.

In this embodiment, since the glass 11 is inorganic, the innermost layer in direct contact with the glass 11 is configured as the organic layer 21, which can bond better with the glass 11 and increase adhesion. Setting the outermost layer also as the organic layer 21, as shown in FIGS. 1-4, when applying the quantum dot package 100 to the quantum dot LED chip 200, the quantum dot package 100 may be adhered to the flip-chip quantum dot LED chip 200. The outermost layer 21 of the quantum dot package 100 is the organic layer 21, and organic adhesive is used for bonding. The organic adhesive easily bonds with the organic layer 21, facilitating adhesion to the quantum dot LED chip 200.

Furthermore, the thickness of the organic layer 21 at the innermost layer is greater than or equal to 100nm, while the thickness range for the remaining organic layers 21 and inorganic layers 22 is: 40nm to 50nm.

That is, by designing the innermost organic layer 21 to have the greatest thickness, it can provide cushioning and protection for the carrier 10 (in this embodiment, the glass 11), achieving more comprehensive protection for the carrier 10, and also facilitating the attachment and fixation of the inorganic layer 22 of the sub-innermost layer (the second layer).

Please refer to FIGS. 1-4, the embodiments of the present application further provide a quantum dot LED chip 200, which includes an electrode 230 and the quantum dot package 100 according to the above embodiments. In one implementation, the quantum dot LED chip 200 is a flip LED chip, with an electrode 230 provided on one side of the quantum dot LED chip 200, and the quantum dot package 100 is disposed on the opposite side of the quantum dot LED chip 200 relative to the electrode 230. Light emitted from the quantum dot LED chip 200 can pass through the quantum dot package 100 to excite the quantum dots within the quantum dot package, emit light having a specific wavelength. In this example, the quantum dot package 100 is bonded onto the flip-chip LED chip using a transparent adhesive, forming the quantum dot LED chip 200, for instance, bonded above the transparent substrate of the flip chip.

In other embodiments, the quantum dot package 100 may also be connected to the quantum dot LED chip 200 by other connection methods. Please refer to FIG. 1-5, in another implementation, the quantum dot LED chip 200 includes a bonding layer 210 and an epitaxial layer 220. The electrode 230 and the quantum dot package 100 are located on opposite sides of the quantum dot LED chip 200, with the quantum dot package 100 and the electrode 230 positioned at opposite ends of the entire quantum dot LED chip 200. One side of the bonding layer 210 is connected to the quantum dot package 100 via bonding, while the other side is connected to the epitaxial layer 220. The epitaxial layer 220 includes an N-type semiconductor layer 221 and a P-type semiconductor layer 222, and a multiple-quantum-well light-emitting layer 223 between the N-type semiconductor layer 221 and the P-type semiconductor layer 222. The electrode 230 is provided on the outermost side of the epitaxial layer 220, including a first electrode 231 electrically connected to the N-type semiconductor layer 221 and a second electrode 232 connected to the P-type semiconductor layer. The sides of the quantum dot LED chip 200 are coated with a light-blocking adhesive layer 240.

Bonding refers to a connection method that utilizes chemical or physical bonds to join two or more materials. In this embodiment, the quantum dot package 100 is disposed on the quantum dot LED chip 200 via bonding, without requiring additional adhesive. This bonding connection provides stronger bonding strength and is less prone to failure compared with adhesive bonding. In this embodiment, the bonding layer 210 is SiO₂, and the substrate of the quantum dot LED chip 200 may be removed, so that even with the addition of the quantum dot package 100, the thickness of the quantum dot LED chip 200 does not increase significantly, thereby minimizing the overall thickness. In an embodiment, the bonding layer 210 may also be the substrate of the quantum dot LED chip 200. To allow light emitted from the quantum dot LED chip 200 to pass through the substrate into the quantum dot package 100, the substrate must be transparent, such as a sapphire substrate. The quantum dot package 100 may be bonded to the substrate of the quantum dot LED chip 200 via a bonding process, thereby being mounted on the quantum dot LED chip 200 to form a quantum dot LED chip. When the quantum dot LED chip 200 operates, the quantum dot material is located above the multiple-quantum-well light-emitting layer 223. Light emitted by the multiple-quantum-well light-emitting layer 223 can penetrate the bonding layer 210 and the quantum dot package 100, exciting the quantum dot material to emit light of a specific wavelength.

In this embodiment, the function of the light-blocking adhesive layer 240 is to prevent light emitted from the quantum dot LED chip 200 from leaking out from the sides of the chip. Therefore, the height of the light-blocking adhesive layer 240 should at least cover the epitaxial layer 220 of the quantum dot LED chip 200 (including the N-type GaN layer (i.e., the N-type semiconductor layer 221), the multiple-quantum-well light-emitting layer 223, and the P-type GaN layer (i.e., the P-type semiconductor layer 222)). However, the light-blocking adhesive layer 240 must not cover the upper surface of the quantum dot package 100 to avoid affecting the light output efficiency of the quantum dot LED chip 200, nor should it cover the electrodes 230 of the quantum dot LED chip 200. In this embodiment, the height of the light-blocking adhesive layer 240 is flush with the upper surface of the quantum dot package 100. This has the advantage that, in addition to preventing light leakage from the sides of the chip, the light-blocking adhesive layer 240 can also protect the sides of the quantum dot package 100. In other embodiments, the height of the light-blocking adhesive layer 240 may also be lower than the upper surface of the quantum dot package 100 (refer to FIG. 1-7d), thereby reducing the amount of light-blocking adhesive material used.

In an embodiment, the light-blocking adhesive layer 240 may be a white adhesive layer formed by mixing silicone with white reflective particles and curing. The white reflective particles can reflect light emitted from the sides of the quantum dot LED chip 200 back into the interior of the quantum dot LED chip 200, causing most of the light from the quantum dot LED chip 200 to be emitted from the top surface. Most of the light emitted from the top surface of LED chip can excite the quantum dot material to emit light of a specific wavelength, thereby improving light conversion efficiency. Moreover, the white reflective particles do not absorb light, resulting in low light loss and high light extraction efficiency, making it suitable for use as a backlight source in backlight products. Silicone has the advantages of good stability, excellent blue light resistance, and good anti-yellowing properties, making it particularly suitable for use with blue light chips in backlight products. Since the white particles have a reflective effect, in this embodiment, the light-blocking adhesive layer 240 may also be referred to as a reflective layer.

In another embodiment, the light-blocking adhesive layer 240 may be a black adhesive layer formed by mixing epoxy adhesive with black particles or black pigment and curing. The black particles can reflect the light emitted from the side of the quantum dot LED chip 200 back into the interior of the quantum dot LED chip 200, while absorbing some of the light, reducing the side emission of the quantum dot LED chip 200 and increasing the top emission. Most of the light emitted from the top can excite the quantum dot material to emit light of a specific wavelength, making it very suitable for use in LED direct type display products. In LED direct type display, the display pixels include quantum dot LED chips 200, with a large number of quantum dot LED chips 200 forming a display pixel array, resulting in high brightness. Therefore, even though black particles absorb light, the impact on display brightness is minimal. Moreover, the black light-blocking adhesive layer prevents optical crosstalk between adjacent quantum dot LED chips 200, increasing display contrast and improving display quality. Additionally, epoxy adhesive has the advantages of high density, good airtightness, and strong adhesion, making it very suitable for LED direct type display products.

As shown in FIGS. 1-6 and 1-7a to 1-7d, in addition, the present application further provides a method for manufacturing the aforementioned quantum dot LED chip 200, specifically including the following steps:

Step a: a substrate is provided, allowing an epitaxial layer 220 to grow on the substrate, where the epitaxial layer 220 includes an N-type semiconductor layer 221 and a P-type semiconductor layer 222, and a multiple-quantum-well light-emitting layer 223 located between the N-type semiconductor layer 221 and the P-type semiconductor layer 222; the epitaxial layer 220 is covered with a bonding layer 210.

Specifically in this embodiment, referring to FIGS. 1-7a, a bonding layer 210 is covered on the surface of the epitaxial layer 220. In this embodiment, the bonding layer 210 is SiO₂. In this embodiment, a SiO₂ thin film layer is covered on the surface of the GaN epitaxial layer as the bonding layer 210. For example, an electron beam evaporation method may be used to deposit and form the SiO₂ thin film layer on the surface of the GaN epitaxial layer, with an evaporation vacuum between 1E10⁻⁶Torr and 1E⁻⁵Torr, and an evaporation temperature at 120°C -300°C ;

In this embodiment, the substrate is a sapphire substrate, the epitaxial layer 220 is a GaN epitaxial layer, the N-type semiconductor layer 221 is an N-type GaN layer, and the P-type semiconductor layer 222 is a P-type GaN layer. In other embodiments, other substrates may also be used, such as a SiC substrate or a Si substrate; the epitaxial layer 220 may also be other types of epitaxial layers.

Step b: the quantum dot package 100 is bonded with the bonding layer 210.

Specifically, referring to FIG. 1-7b, the quantum dot package 100 described in Embodiment 1 is provided, surface cleaning, chemical mechanical polishing, and activation treatment are performed on the quantum dot package 100 and on the bonding layer 210 covering the surface of the epitaxial layer 220.

In this embodiment, the surface of the quantum dot package 100 is preferably a SiO₂ layer, with the advantage of high bonding strength with the bonding layer 210, which is also SiO₂.

Then the activated surface of the quantum dot package 100 is connected with the activated surface of the bonding layer 210, and the quantum dot package 100 and the bonding layer 210 are bonded into one unit under high temperature and high pressure.

In this embodiment, after activation, hydroxyl groups (-O-H) form on the surfaces of the quantum dot package 100 and the SiO₂ layer, and the quantum dot package 100 and SiO₂ are bonded into one unit under high temperature and high pressure. Thus, the quantum dot package 100 is connected to the epitaxial layer 220 via the bonding layer 210.

Step c: the substrate is removed, and an electrode 230 is fabricated on the epitaxial layer 220 to form a chip prototype 200'.

Referring to FIG. 1-7c, in this embodiment, the sapphire substrate is removed using a laser, offering the advantages of high efficiency and low cost. In other embodiments, other chemical (e.g., etching) or physical (e.g., grinding) methods may also be used to remove the substrate.

An electrode 230 is fabricated on the epitaxial layer 220; the electrode 230 is located at the outermost side of epitaxial layer 220, including a first electrode electrically connected to the N-type semiconductor layer 221 and a second electrode connected to the P-type semiconductor layer 222, forming the chip prototype 200'.

In this embodiment, the process for fabricating electrode 230 may adopt mature techniques from existing technology. For example, first photolithography is used to remove part of the epitaxial layer 220, at least partial surfaces of the N-type semiconductor layer 221 and the P-type semiconductor layer 222 are exposed, then a metal film layer is sputtered on the surface of the epitaxial layer 220 to form a first electrode electrically connected to the N-type semiconductor layer 221 and a second electrode connected to the P-type semiconductor layer 222. Specifically, in this embodiment, photolithography is used to etch specific structures P-GaN and N-GaN on the GaN epitaxial layer, then sputter a metal film layer on the surfaces of P-GaN and N-GaN to form the electrode 230.

Step d: a light-blocking adhesive layer 240 is formed on the side surface of the epitaxial layer 220 of the chip prototype 200' to obtain a complete quantum dot LED chip 200.

Specifically, referring to FIG. 1-7d, a plurality of chip prototypes 200' may first be arranged to form a chip array neatly aligned in a first direction (the X direction indicated by the dashed arrow in FIG. 1-7d) and a second direction (the Y direction indicated by the dashed arrow in FIG. 1-7d), where gaps exist between the quantum dot LED chips 200; the first direction and the second direction are perpendicular to each other.

In this embodiment, a plurality of chip prototypes 200' are arranged in a rectangular array, with the electrodes 230 of each quantum dot LED chip 200 all facing downward or all facing upward, and the spacing between each quantum dot LED chip 200 being equal. To maintain the stability of each quantum dot LED chip 200, a horizontal bearing surface with a certain degree of adhesion may be provided below the quantum dot LED chips 200, thereby firmly adhering the bottom of each quantum dot LED chip 200 to the horizontal bearing surface. Since the outer profile of the quantum dot LED chip 200 is generally square, the first direction and the second direction are perpendicular, facilitating the arrangement of the quantum dot LED chips 200 and subsequent cutting operations.

Then, the gaps between adjacent quantum dot LED chips 200 in the chip array are filled with light-blocking adhesive, and a curing process is performed to form the light-blocking adhesive layer 240.

In this embodiment, the light-blocking adhesive layer 240 may be formed by mixing silicone with white reflective particles; or by mixing epoxy adhesive with black particles. The light-blocking adhesive layer 240 must at least cover the epitaxial layer 220 of the quantum dot LED chip 200 to serve the light-blocking function.

Finally, the chip array is cut along the gaps between the quantum dot LED chips 200 to obtain a plurality of finished quantum dot LED chips 200, each with its side surfaces coated with the light-blocking adhesive layer 240.

In this embodiment, nano-pores are formed on the carrier 10 (for example, glass 11) by electrochemical etching on the quantum dot package 100, and quantum dots are encapsulated therein. The quantum dot package 100 is separated from the epitaxial layer 220 by a bonding layer 210. The bonding layer 210 serves to bond and connect the quantum dot package 100 and also serves to protect the epitaxial layer 220.

In the present application, a quantum dot LED chip 200 is prepared by using the above manufacturing method. The introduction of the quantum dot material does not affect the P-N junction epitaxial structure of the quantum dot LED chip 200 itself and does not affect its quantum well light-emitting performance. Meanwhile, a light-blocking adhesive layer 240 is formed around the quantum dot LED chip 200 to effectively prevent blue light leakage. In addition, the substrate is removed in this embodiment, thereby reducing the thickness of the quantum dot LED chip 200 as much as possible, which facilitates product miniaturization and ultra-thin design.

In this embodiment, in step b, the quantum dot package 100 and the bonding layer 210 are bonded into an integral structure by joining the activated surface of the quantum dot package 100 with the activated surface of the bonding layer 210 under high temperature and high pressure. The specific method is as follows:

Chemical mechanical polishing is carried out on the bonding layer 210 of the quantum dot package 100 (which is a SiO₂ film layer in this embodiment) to obtain a flat and clean polished surface. The remaining depth of the SiO₂ film after polishing is 1 µm-3 µm, with a surface roughness of Ra < 0.1 µm;

The polished surfaces of the quantum dot package 100 and the bonding layer 210 are cleaned and activated using a mixed solution of hydrochloric acid and hydrogen peroxide, thereby forming hydroxyl groups on the surfaces of the quantum dot package 100 and the bonding layer 210. Then, high-temperature and high-pressure bonding is carried out, with a bonding temperature of 300°Cto 500°C, a bonding pressure of 8000kg to 12000kg, and a bonding time of 900s-1200s.

Thus, the bonding strength and quality between the quantum dot package 100 and the bonding layer 210 can be improved, resulting in better integrity after bonding.

### Embodiment 2

In this embodiment, as shown in FIGS. 2-5, the quantum dot material 624 is encapsulated within a portion of the epitaxial layer of the quantum dot LED chip and is located above the multiple-quantum-well light-emitting layer 622. The epitaxial layer therefore serves as the carrier of the quantum dot material 624. A plurality of nanopores 623 are formed in the epitaxial layer, and the quantum dot material 624 is loaded into these nanopores 623. As shown in FIG. 2-5a, in another embodiment, the quantum dot material 624 is encapsulated on the light-transmitting substrate 621 of a flip chip, such that the light-transmitting substrate 621 serves as the carrier for the quantum dot material 624. A plurality of nanopores 623 are formed on or within the light-transmitting substrate 621, and the quantum dot material 624 is loaded into these nanopores 623. The quantum dot material 624 includes quantum dot particles 630 and may further include a light-transmitting sealing material 629 that encapsulates the quantum dot particles.

### Embodiment 3

Please refer to FIGS. 1-8. Furthermore, based on any of the above embodiments, the present application further provides an LED package device, which includes a package body and a quantum dot LED chip 200 encapsulated within the package body. The quantum dot LED chip 200 is the quantum dot LED chip described in Embodiment 1 above.

The package body includes a lead frame 300 and an encapsulating adhesive 400 . The lead frame 300 is provided with a package cavity. The quantum dot LED chip 200 is mounted within the package cavity. Solder paste 500 is provided at the bottom of the packaging cavity to solder and secure the quantum dot LED chip 200. The encapsulating adhesive 400 fills the package cavity so as to encapsulate the quantum dot LED chip 200 within the package body. The encapsulating adhesive 400 may optionally include phosphor powders emitting other colors of light, or may be free of phosphor. After the encapsulating adhesive 400 is cured, an LED package device using the quantum dot LED chip is obtained, offering advantages of excellent hermetic performance and high reliability in use.

### Embodiment 4

Referring to FIGS. 2-1 and 2-4, as an application of a quantum dot LED chip, the present embodiment provides a light-emitting device, including a phosphor film sheet 71 and at least one chip group 60a composed of a first light-emitting chip 61 and a second light-emitting chip 62, as well as a circuit (not shown) electrically connected to the chip group 60a. In this embodiment, the circuit is arranged on a substrate 80, which may be a PCB circuit board, a ceramic substrate, or a glass substrate. In this embodiment, the light-emitting device includes a film group 70 composed of a plurality of optical films. The film group may include optical films such as a brightness enhancement film and a diffusion film (not shown). In this embodiment, the phosphor film sheet 71 is disposed on one layer of the film group 70. With reference to FIGS. 2-1 to 2-3, the chip group 60a includes at least one first light-emitting chip 61 and at least one second light-emitting chip 62. Both the first light-emitting chip 61 and the second light-emitting chip 62 are flip chips. The first light-emitting chip 61 is configured to emit light of a first color. In the embodiment, the first light-emitting chip 61 is a GaN (gallium nitride) blue LED chip, and the first color is blue. In other embodiments, the first light-emitting chip 61 may also be a chip that emits other colors, which is not limited in the present application.

Referring to FIGS. 2-5 and 2-5a, the second light-emitting chip 62 includes a light-transmitting substrate 621, a multiple-quantum-well light-emitting layer 622, and quantum dot (QD) material 624. A plurality of nanopores 623 are provided above the multiple-quantum-well light-emitting layer 622. In order to achieve uniform light output, the nanopores 623 are preferably uniformly distributed above the multiple-quantum-well light-emitting layer 622. The nanopores 623 are filled with quantum dot (QD) material 624 of a second color. In one example, referring to FIG. 2-5, an n-GaN (N-type gallium nitride) layer 625 is provided between the light-transmitting substrate 621 and the multiple-quantum-well light-emitting layer 622, and the nanopores 623 may be formed by electrochemically etching the n-GaN layer 625 of the light-emitting chip. A p-GaN (P-type gallium nitride) layer 626 is further provided on the opposite side of the multiple-quantum-well light-emitting layer 622 relative to the n-GaN layer 625. such that the multiple-quantum-well light-emitting layer 622 is located between the n-GaN layer 625 and the p-GaN layer 626. In an example, referring to FIG. 2-5a, the light-transmitting substrate 621 is also located above the multiple-quantum-well light-emitting layer 622, and the nanopores 623 may be formed by electrochemically etching the light-transmitting substrate 621, so that the quantum dot material 624 can be disposed on the light-transmitting substrate 621. Preferably, the quantum dot material 624 is disposed in a portion of the light-transmitting substrate 621 close to the upper surface thereof, which facilitates manufacturing. At least a portion of the lower part of the light-transmitting substrate 621 does not contain the quantum dot material 624, which can play a role of isolating some heat from the quantum dot material 624.

The light emitted by the multiple-quantum-well light-emitting layer 622 of the second light-emitting chip 62 is used to excite the quantum dot material 624 to emit light of a second color. In this embodiment, the second color is red, while the light emitted by the multiple-quantum-well light-emitting layer 622 of the second light-emitting chip 62 is blue, and the quantum dot material is a red quantum dot. In other embodiments, the second color may be other colors, and the light emitted by the multiple-quantum-well light-emitting layer 622 of the second light-emitting chip 62 may also be other colors. The phosphor film sheet 71 covers the first light-emitting chip 61 and the second light-emitting chip 62, and the phosphor film sheet 71 includes a phosphor that is excited by the first-color light emitted by the first light-emitting chip 61 to emit light of a third color. In this embodiment, the phosphor is a green phosphor, preferably a β-sialon type nitride phosphor, and the third color is green. The first color, second color, and third color mix above the first light-emitting chip 61, second light-emitting chip 62, and phosphor film sheet 71 to form white light. In this embodiment, the first color is blue, the second color is red, and the third color is green; red, green, and blue combine above the phosphor film to form white light.

In this embodiment, the second light-emitting chip generates red light by exciting quantum dots with blue light emitted from the multiple-quantum-well light-emitting layer 622, therefore it may be referred to as a red quantum dot LED chip. Referring to the example in FIGS. 2-5, in this embodiment, the red quantum dot LED chip is fabricated by electrochemically etching a GaN layer to form nanopores, then loading red quantum dot material into the nanopores. The red quantum dot material is excited by blue light and converted to emit red light. The chip is essentially based on GaN epitaxial material, which is the same as the epitaxial material used in conventional (currently commonly used) blue light chips, differing from the GaAs epitaxial material of traditional (currently commonly used) red light chips:

| Luminescence mechanism of red quantum dot LED chip: | Luminescence mechanism of red light chip: |
|---|---|
| Electrons and holes recombine in the GaN multiple-quantum-well light-emitting layer to emit blue light (electroluminescence process); the blue light excites the red quantum dot material loaded in the nanopores to emit red light (photoluminescence process) | Electrons and holes recombine in the GaAs a plurality of quantum well to emit red light (electroluminescence process) |

From the above comparison, it can be seen that in this embodiment, the red quantum dot LED chip may replace the red light chip to emit red light. Therefore, the light-emitting device provided in this embodiment may operate without using traditional (commonly used) red light chips. Thus, the second light-emitting chip 62 may be designed and manufactured based on the production process and fabrication technology of blue LED chips, such that the difference between the first light-emitting chip 61 and the second light-emitting chip 62 is small, which helps reduce and control production costs. Moreover, the first light-emitting chip 61 and the second light-emitting chip 62 are semiconductor devices of the same material system (e.g., both are GaN-based semiconductor devices), with similar or identical driving voltages and currents, facilitating simplified circuit design and lowering product development costs.

It should be noted that, similar to the red quantum dot LED chip mentioned above, if the second light-emitting chip 62 generates green light by exciting quantum dot material with light emitted from the multiple-quantum-well light-emitting layer 622, it may be referred to as a green quantum dot LED chip; if it generates blue light by exciting quantum dot material with light emitted from the multiple-quantum-well light-emitting layer 622, it may be called a blue quantum dot LED chip. Since blue light has higher energy and is more suitable as an excitation light source for quantum dot material, the light emitted by the multiple-quantum-well light-emitting layer 622 of the second light-emitting chip 62 in this embodiment is preferably blue light. If the quantum dot material includes a plurality of types of quantum dots, for example, if it includes red and green quantum dots, then the light from the multiple-quantum-well light-emitting layer 622 of the second light-emitting chip 62 can excite the quantum dots to produce red light and green light; thus, the second light-emitting chip 62 may also be called a red-green quantum dot LED chip. If the light emitted by the quantum dot LED chip mixes with the light from the multiple-quantum-well light-emitting layer 622 to form white light, then the second light-emitting chip 62 may also be called a white quantum dot LED chip. In this way, if the second light-emitting chip 62 (white quantum dot LED chip) is disposed in a light-emitting device, it does not need to be combined with other chips to form a chip group and may directly serve as a high-color-gamut white light source.

In other embodiments, the first color is preferably blue; the second color may be one of red or green; the third color is one of green or red, and the third color differs from the second color, with the three different colors mixing to form white.

In an embodiment, the light-transmitting substrate 621 of the second light-emitting chip 62 is a sapphire substrate, which has good light transmittance and high hardness.

In an embodiment, the quantum dot material 624 includes quantum dot particles 630 and a light-transmitting sealing material 629 for sealing the quantum dot particles 630 in the nanopores 623.

In an embodiment, referring to FIGS. 2-4, the chip group 60a further includes a lens 90 covering the first light-emitting chip 61 and the second light-emitting chip 62, which facilitates light divergence.

In one embodiment, there are a plurality of chip groups 60a arranged in a matrix. In an example, a circuit (not shown) includes a first circuit (not shown) for controlling the first light-emitting chip 61 in each chip group 60a, and a second circuit (not shown) independent of the first circuit for controlling the second light-emitting chip 62. In an example, the control voltages for the first light-emitting chip 61 and second light-emitting chip 62 are the same, which helps simplify circuit design.

In one embodiment, referring to FIG. 2-1, the chip group 60a includes one first light-emitting chip 61 and one second light-emitting chip 62. In an example, the first light-emitting chip 61 and the second light-emitting chip 62 are arranged side by side, and the spacing a between the first light-emitting chip 61 and the second light-emitting chip 62 is controlled between ≥30 µm and ≤ 100 µm, which facilitates light mixing. Referring to FIG. 2-1a, in the circuit, the first light-emitting chip 61 and the second light-emitting chip 62 may be connected in series; referring to FIG. 2-1b, the first light-emitting chip 61 and the second light-emitting chip 62 may also be set independently in the circuit, and series or parallel circuit configurations may be further implemented on the corresponding circuit.

In practical applications, since the light emitted by the multiple-quantum-well light-emitting layer 622 of the second light-emitting chip 62 is used to excite quantum dots, and combined with the light from the first light-emitting chip 61 to excite phosphor for a white light solution, typically the higher the white light color gamut achieved, the greater the corresponding brightness loss. To enhance brightness while achieving high color gamut white light, one first light-emitting chip 61 may be paired with two second light-emitting chips 62 to compensate for the brightness loss.

In an embodiment, the chip group 60a includes one first light-emitting chip 61 and two second light-emitting chips 62. In an example, referring to FIG. 2-2, the two second light-emitting chips 62 are respectively disposed on two sides of the first light-emitting chip 61, thereby providing a symmetrical light distribution, sufficient brightness, and good emission uniformity. In another example, the two second light-emitting chips 62 may alternatively be arranged on the same side of the first light-emitting chip 61. In terms of circuit design, the two second light-emitting chips 62 may be connected in series with the first light-emitting chip 61 and controlled simultaneously. In one example, referring to FIG. 2-2b, in the circuit the two second light-emitting chips 62 may also be connected in series and independently controlled relative to the first light-emitting chip 61. Further series or parallel circuit configurations may be implemented in a corresponding circuit.

In an embodiment, the chip group 60a includes one first light-emitting chip 61 and four second light-emitting chips 62. In an example, referring to FIG. 2-3, two second light-emitting chips 62 are disposed on the same side as the first light-emitting chip 61, while the remaining two second light-emitting chips 62 are disposed on the opposite side, thereby providing advantages such as symmetric light pattern, sufficient brightness, and good uniformity. In another example, the four second light-emitting chips 62 may alternatively be disposed on four respective sides of the first light-emitting chip 61. In an example, referring to FIG. 2-3a, the four second light-emitting chips 62 may be connected in series with the first light-emitting chip 61 and controlled simultaneously; In an example, referring to FIG. 2-3b, the four second light-emitting chips 62 are connected in series and independently controlled relative to the first light-emitting chip 61, and further series or parallel circuit configurations may be implemented in a corresponding circuit.

In the above light-emitting device provided by the present application, since the quantum dot material is disposed within the second light-emitting chip 62, there is no need to provide an expensive QD (quantum dot) film above the first light-emitting chip 61 and the second light-emitting chips 62. Only a lower-cost phosphor film sheet 71 needs to be disposed above the light-emitting chips to achieve high-color-gamut white light, which may reduce production costs.

### Embodiment 5

Referring to FIGS. 2-1, 2-2, 2-3, 2-6, and 2-7, the present application further provides another light-emitting device, including at least one light source assembly 60b (reference numeral 60a in FIGS. 2-1, 2-2, and 2-3 may also denote light source assembly 60b) including a second light-emitting chip 62 and an LED package device 61p, and a circuit electrically connected to the light source assembly 60b. Referring to FIG. 2-6, the LED package device 61p includes a substrate 611, a first light-emitting chip 61, and a fluorescent glue 612. In the light source assembly 60b, the second light-emitting chip 62 is a flip chip; the first light-emitting chip 61 may be a wire-bonded chip or a flip chip; the first light-emitting chip 61 is configured to emit light of a first color. In this embodiment, the second light-emitting chip 62 is identical to the second light-emitting chip 62 in Embodiment 4.

The fluorescent glue 612 covers the first light-emitting chip 61 and includes phosphor that is excited by the first-color light emitted from the first light-emitting chip 61 to emit third-color light. In this embodiment, the phosphor is mixed into the encapsulant to form the fluorescent glue 612, which is then disposed over the first light-emitting chip 61; the first, second, and third colors mix above the LED package device 61 and the second light-emitting chip 62 to form white light. Since the LED package device 61p in this embodiment includes phosphor and can produce the third color, it may eliminate the need for an additional phosphor film on the LED light-emitting device, thereby reducing costs.

In the LED package device 61p of this embodiment, a layer of white encapsulant 613 is disposed over the fluorescent glue 612 to protect it. In other embodiments, the white encapsulant 613 may be omitted.

In this embodiment, the first light-emitting chip 61 is a blue-light chip, and the fluorescent glue in the LED package device 61p includes β-Sialon phosphor, which may be excited by blue light to produce green light, thereby mixing with the red light generated by the second light-emitting chip 62 and the blue light from the first light-emitting chip 61 to produce high-color-gamut white light.

In this embodiment, the LED package device 61p has no light-blocking structure on its sides, allowing light emission from both the top and all four sides, offering the advantage of high light extraction efficiency.

In this embodiment, refer to the examples in FIG. 2-1, FIG. 2-2, and FIG. 2-3. In the example shown in FIG. 2-1, the light source assembly 60b may include one LED package device 61p and one second light-emitting chip 62, arranged side by side; in the example shown in FIG. 2-2, the light source assembly 60 may also include one LED package device 61p and two second light-emitting chips 62, where the two second light-emitting chips 62 may be respectively disposed on both sides of the LED package device 61p; in the example shown in FIG. 2-3, the light source assembly 60 may include one LED package device 61p and four second light-emitting chips 62, with two second light-emitting chips 62 arranged longitudinally on each side of the LED package device 61p.

In this embodiment, the second light-emitting chip 62 is a red quantum dot LED chip based on a blue light-emitting chip, and its multiple-quantum-well light-emitting layer 622 emits blue light. Thus, the second light-emitting chip 62 in this embodiment is structurally similar to the first light-emitting chip 61, both may be GaN-based light-emitting chips, and their control voltage and control current may be the same, facilitating circuit control.

Referring to FIG. 2-7, the light-emitting device provided in this embodiment also includes a film set 70 including a plurality of optical films. The film set 70 includes optical films such as a brightness enhancement film and a diffusion film, but the film set 70 does not include a phosphor film. To protect the chip group 60b, the chip group 60b also includes a lens 90 covering the first light-emitting chip 61 and the LED package device 61p.

In this embodiment, other aspects not specifically described herein is the same as the corresponding content in Embodiment 4.

### Embodiment 6

The difference between this embodiment and Embodiment 4 is that, in this embodiment, a third light-emitting chip 63 may be used to generate light of a third color, replacing the light of the third color generated by excitation of the phosphor film sheet 71 in Embodiment 1, thereby eliminating the phosphor film 71. Specifically:

Referring to FIGS. 2-8 and 2-7, the present application further provides another light-emitting device, including at least one chip group 60c composed of a first light-emitting chip 61, a second light-emitting chip 62 and a third light-emitting chip 63, and a circuit electrically connected to the chip group 60c. The chip group 60c includes at least one first light-emitting chip 61, at least one second light-emitting chip 62, and at least one third light-emitting chip 63. The first light-emitting chip 61, the second light-emitting chip 62 and the third light-emitting chip 63 are all flip chips. The first light-emitting chip 61 is configured to emit light of a first color. In this embodiment, the second light-emitting chip 62 is identical to the second light-emitting chip described in Embodiment 4 and emits light of a second color. The third light-emitting chip 63 is configured to emit light of a third color. The first color, the second color, and third color mix above the chip group 60c to form white light.

In this embodiment, preferably, the first chip 61 is a blue light chip, the second chip 62 is a red quantum dot LED chip, and the third chip 63 is a green light chip or a green quantum dot LED chip. In an example, the red quantum dot LED chip is preferably a blue chip-based red quantum dot LED chip (the light emitted by the multiple-quantum-well light-emitting layer is blue light); In an example, the green quantum dot LED chip is preferably a blue chip-based green quantum dot LED chip (the light emitted by the multiple-quantum-well light-emitting layer is blue light). Thus, in this embodiment, the first light-emitting chip 61, the second light-emitting chip 62, and the third light-emitting chip 63 have similar structures, all may be GaN-based light-emitting chips, and their control voltages and control currents may be the same, facilitating circuit control.

Referring to FIG. 2-7 (the label 60b in FIG. 2-7 may also represent the chip group 60c), similar to Embodiment 5, the light-emitting device provided in this embodiment also includes a film set 70 including a plurality of optical films; the film set 70 includes optical films such as a brightness enhancement film and a diffusion film, but the film set 70 does not include a phosphor film. To protect the chip group 60c, the chip group 60c also includes a lens 90 covering the first light-emitting chip 61, the second light-emitting chip 62, and the third light-emitting chip.

In this embodiment, other contents not specifically described are the same as the corresponding contents in Embodiment 4.

### Embodiment 7

Referring to FIGS. 2-9 and 2-10, the present application further provides an LED package device 60d, including a lead frame 601 and a packaging component 602. The packaging component 602 has a recess 603, with a portion of the lead frame 601 exposed at the bottom of the recess 603 to form pads for bonding light-emitting chips 61,62. The light-emitting chips 61,62 are disposed at the bottom of the recess 603, including a first light-emitting chip 61 and a second light-emitting chip 62, both of which are flip chips. The first light-emitting chip 61 is configured to emit light of a first color; the second light-emitting chip 62 is configured to emit light of a second color. In this embodiment, the second light-emitting chip 62 is the same as that in Embodiment 4, and no further description is provided here. Within the recess 603 of the packaging component 602, a package glue 604 is provided covering the first light-emitting chip 61 and the second light-emitting chip 62, serving to protect them.

The LED package body 60d in this embodiment can only produce light of the first and second colors; to form white light, a third color needs to be mixed in.

Referring to FIG. 2-10, this embodiment further provides a light-emitting device, including the aforementioned LED package body 60d and a film set 70 including a plurality of optical films. In this embodiment, the film set 70 is identical or similar in structure to that in Embodiment 4, also including a phosphor film 71. The phosphor film sheet 71 includes phosphor that, upon excitation by the first-color light emitted from the first light-emitting chip 61, emits light of a third color. In this embodiment, the first light-emitting chip 61 is preferably a blue light chip; the second light-emitting chip 62 is preferably a red quantum dot LED chip; the phosphor is preferably a green phosphor, preferably a β-sialon type nitride phosphor.

In this embodiment, the first color is preferably blue, the second color is preferably red, and the third color is preferably green. The first, second, and third colors mix above the first light-emitting chip 61, the second light-emitting chip 62, and the phosphor film sheet 71 to form white light.

In this embodiment, since the package body 60d is already provided with package glue 604 to protect the first chip 21 and the second chip 22, there is no need to provide a lens 90 over the first chip 21 and the second chip 22 as in Embodiment 4.

### Embodiment 8

Referring to FIGS. 2-11 and 2-12, this present application further provides an LED package device 60e. Different from the Embodiment 7, in this embodiment a fluorescent glue 605 is disposed in the recess 603 of the packaging component 602 and covers the first light-emitting chip 61 and the second light-emitting chip 62. The fluorescent glue 605 includes phosphor that is excited by the first color light emitted from the first light-emitting chip 61 to emit a third color light. The first color, the second color, and the third color mix above the first light-emitting chip 61 and the second light-emitting chip 62 to form white light.

In this embodiment, the first light-emitting chip 61 is preferably a blue light chip. The second light-emitting chip 62 is preferably a red quantum dot LED chip. The phosphor is preferably green phosphor and more preferably a β-sialon nitride phosphor.

Referring to FIG. 2-12, the present application further provides a light-emitting device that includes the LED package body 60e and a film set 70 that includes a plurality of optical films. The film set 70 has the same as or similar structure as the film set in the Embodiment 5 and does not include a phosphor film 71, which reduce cost.

Other contents not specifically described are the same as the corresponding contents in the fourth embodiment, and will not be repeated here.

The above-described embodiments only express several implementations of the present application, with relatively specific and detailed descriptions, but should not be construed as limiting the scope of the patent application. It should be noted that for those of ordinary skill in the art, without departing from the concept of the present application, several modifications and improvements may be made, all of which fall within the protection scope of the present application. Therefore, the protection scope of the present application patent should be based on the appended claims.

## Claims

1. A quantum dot LED chip, comprising a carrier and a multiple-quantum-well light-emitting layer, wherein the carrier is formed of a light-transmitting solid material, a plurality of nanopores are provided on a surface of or within the carrier, and the nanopores are loaded with a quantum dot material; and
the carrier is disposed above the multiple-quantum-well light-emitting layer, and light emitted from the multiple-quantum-well light-emitting layer is capable of exciting the quantum dot material to convert a wavelength emitted by the chip.

2. The quantum dot LED chip according to claim 1, further comprising a coating layer, wherein the coating layer is formed of a light-transmitting material, and the coating layer covers an outer surface of the carrier,
wherein a number of layers of the coating layer is an odd number, an innermost layer and an outermost layer in a thickness direction of the coating layer are both organic layers, and the organic layer at the innermost layer is in direct contact with the carrier; and
wherein a thickness of the organic layer at the innermost layer is greater than or equal to 100 nm, and a thickness range of the remaining organic layers and the inorganic layers each range from 40 nm to 50 nm.

3. The quantum dot LED chip according to claim 1, wherein a material of the organic layers is acrylic, and a material of the inorganic layer is made of any one of AIN, Al₂O₃, Si₄N₃ and SiO₂ and the carrier is glass.

4. The quantum dot LED chip according to claim 1, wherein the chip further comprising a bonding layer and an epitaxial layer, one side of the bonding layer being bonded to the carrier and another side of the bonding layer being connected to the epitaxial layer, the epitaxial layer comprising an N-type semiconductor layer and a P-type semiconductor layer, and the multiple-quantum-well light-emitting layer disposed between the N-type semiconductor layer and the P-type semiconductor layer; and
wherein an electrode is provided on an outermost side of the epitaxial layer, and the electrode comprises a first electrode electrically connected to the N-type semiconductor layer and a second electrode connected to the P-type semiconductor layer; and
wherein a light-blocking adhesive layer covers side surfaces of the epitaxial layer.

5. A light-emitting device, comprising a phosphor film, at least one chip group composed of a first light-emitting chip and a second light-emitting chip, and a circuit electrically connected to the chip group;
wherein the chip group comprises at least one of the first light-emitting chips and at least one of the second light-emitting chips, both the first light-emitting chip and the second light-emitting chip being flip chips;
wherein the first light-emitting chip is configured to emit light of a first color;
wherein the second light-emitting chip comprises the quantum dot LED chip according to claim 1, and light emitted from the multiple-quantum-well light-emitting layer thereof the second light-emitting chip excites the quantum dot material to emit light of a second color;
wherein the phosphor film sheet covers the first light-emitting chip and the second light-emitting chip, and the phosphor film includes phosphor configured to emit light of a third color when excited by the light of the first color emitted from the first light-emitting chip;
wherein the first color, the second color and the third color are mixed above the phosphor film to form white light;
wherein the first color is blue;
wherein the second color is one of red or green;
wherein the third color is one of green or red, and the third color is different from the second color;
wherein the nanopores are provided on a light-transmitting substrate of the second light-emitting chip and/or on a semiconductor material layer between the light-transmitting substrate and the multiple-quantum-well light-emitting layer;
wherein the quantum dot material comprises quantum dots and a light-transmitting sealing material for sealing the quantum dots in the nanopores; and
wherein the light-transmitting sealing material encapsulates quantum dot particles to protect the quantum dot particles from water and oxygen and to some extent block heat.

6. The light-emitting device according to claim 6, wherein the first light-emitting chip is a blue LED chip;
wherein the first color is blue;
wherein the light emitted by the multiple-quantum-well light-emitting layer of the second light-emitting chip is blue light, and the quantum dot material is red quantum dots;
wherein the second color is red, and the red quantum dot emit red when excited by the blue light emitted from the second light-emitting chip; and
wherein the phosphor film sheet includes a green phosphor and the green phosphor is a β-Sialon phosphor.

7. The light-emitting device according to claim 6, wherein the chip group further comprises a lens covering the first light-emitting chip and the second light-emitting chip;
wherein a plurality of chip groups are provided and arranged in a matrix;
wherein the circuit comprises a first circuit for controlling the first light-emitting chips in each chip group and a second circuit independent of the first circuit for controlling the second light-emitting chips;
wherein control voltages of each of first light-emitting chips and the second light-emitting chips are the same; and
wherein a substrate of the second light-emitting chip is a sapphire substrate.

8. A light-emitting device, comprising at least one light source assembly composed of a second light-emitting chip and an LED package device, and a circuit electrically connected to the light source assembly;
wherein the LED package device comprises a substrate, a first light-emitting chip, and a fluorescent glue;
wherein the first light-emitting chip is configured to emit light of a first color;
wherein the second light-emitting chip is configured to emit light of a second color;
wherein the fluorescent glue covers the first light-emitting chip and contains a phosphor configured to emit light of a third color when excited by the light of the first color emitted from the first light-emitting chip;
wherein the first light-emitting chip is a flip chip or a wire-bonded chip, and the second light-emitting chip is a flip chip;
wherein the second light-emitting chip comprises the quantum dot LED chip according to claim 1; and
wherein the first color, the second color, and the third color are mixed above the LED package device and the second light-emitting chip to form white light.

9. A light-emitting device, comprising at least one chip group composed of a first light-emitting chip, a second light-emitting chip, and a third light-emitting chip, and a circuit electrically connected to the chip group;
wherein the chip group comprises at least one first light-emitting chip, at least one second light-emitting chip, and at least one third light-emitting chip, and the first light-emitting chip, the second light-emitting chip, and the third light-emitting chip are all flip chips;
wherein the first light-emitting chip is configured to emit light of a first color;
wherein the second light-emitting chip is configured to emit light of a second color;
wherein the second light-emitting chip comprises the quantum dot LED chip according to claim 1;
wherein the third light-emitting chip is configured to emit light of a third color; and
wherein the first color, the second color, and the third color are mixed above the chip group to form white light.

10. An LED package device, comprising a lead frame and a packaging component, wherein the package device is provided with a recess, and a portion of the lead frame is exposed at a bottom of the recess to form pads for soldering light-emitting chips, the light-emitting chips being disposed at the bottom of the recess;
wherein the light-emitting chips comprise a first light-emitting chip and a second light-emitting chip, and the first light-emitting chip and the second light-emitting chip are both flip chips;
wherein the first light-emitting chip is configured to emit light of a first color;
wherein the second light-emitting chip is configured to emit light of a second color;
wherein the second light-emitting chip comprises the quantum dot LED chip according to claim 1;
wherein a fluorescent glue covering the first light-emitting chip and the second light-emitting chip is provided in the recess of the packaging component, and the fluorescent glue contains a phosphor configured to emit light of a third color when excited by the light of the first color emitted from the first light-emitting chip; and
wherein the first color, the second color, and the third color are mixed above the first light-emitting chip and the second light-emitting chip to form white light.
